# EUROPEAN PATENT SPECIFICATION

(11) **EP 0 377 978 B1**
(45) Date of publication and mention of the grant of the patent: **14.06.1995**
(21) Application number: 89313083.1
(22) Date of filing: 14.12.1989
(51) Int. Cl.: H03L 7/093, H03F 3/45

(54) **A PLL control apparatus**
Steuerschaltung für eine PLL Schaltung
Appareil de commande pour un circuit PLL

(30) Priority: 30.05.1989 JP 138592/89; 15.12.1988 JP 317068/88; 27.09.1989 JP 250903/89
(43) Date of publication of application: 18.07.1990
(73) Proprietor: MITSUBISHI DENKI KABUSHIKI KAISHA, Tokyo (JP)
(72) Inventor: Itoh, Takashi c/o Mitsubishi Denki K.K., Nagaokakyo-shi Kyoto (JP)
(74) Representative: Beresford, Keith Denis Lewis

(56) References cited:
- EP-A- 0 153 868
- US-A- 3 717 821
- US-A- 3 984 780
- US-A- 4 021 752
- US-A- 4 429 283
- PATENT ABSTRACTS OF JAPAN, vol. 11, no. 304 (E-545)[2751], 3rd October 1987;& JP-A-62 97 428
- ELECTRONICS LETTERS, vol. 14, no. 11, May 1978, pages 342,343; M.J. UNDERHILL et al.: "Fast digital frequency synthesiser"
- ELECTRONIC LETTERS, vol. 25, no. 10, 11th May 1989, pages 673-675; Z. WANG et al.: "Adjustable bidirectional MOS current mirror/amplifier"

## Description

The present invention relates to a phase locked loop control apparatus.

A prior art control apparatus will be described. In the following description, a variable frequency oscillator (hereinafter referred to as "VFO") is used as a variable frequency generating means.

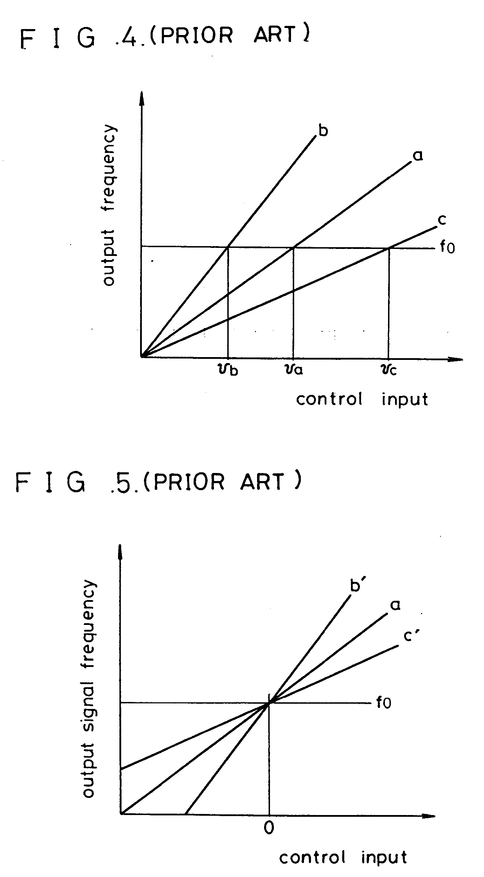

The VFO, which is an important constitutional element of a PLL circuit, has variations dependent on its component elements, and further it is well known that it has variations dependent on the usage environment such as power supply voltage. Figure 4 shows an example of control input vs. output frequency characteristics of the VFO. In the figure, reference character "a" represents a characteristic which is to be the design centre, and reference characters "b" and "c" represent characteristics in a case where the characteristic of the VFO varies. In order to enable a preferable operation as a PLL by using such three kinds of VFOs to obtain a predetermined frequency f₀, input signals of vₐ, v_{b}, and v_{c} are required as control inputs of the VFOs. As a method of automatically correcting the variations of the characteristics of the VFO, there is a technique disclosed in Japanese Laid-open Patent Publication No. Sho 62-97428.

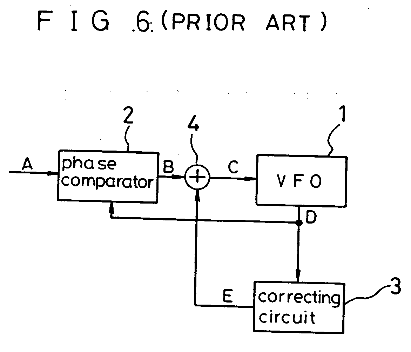

Figure 6 is a block diagram of a control apparatus which conducts such an automatic correction. In figure 6, reference numeral 1 denotes a VFO outputting a variable frequency signal D, the frequency of which varies in response to the control signal C. Reference numeral 2 denotes a phase comparator circuit for detecting the phase difference between the variable frequency signal D and the input signal A from the outside to output an error detection signal B. Reference numeral 3 denotes a correction circuit for detecting the deviation of the frequency of the variable frequency signal D from a predetermined value (f₀) to output a correction signal E. Reference numeral 4 denotes an adder.

The device will operate as follows.

When the input signal A does not exist, the phase comparator 2 outputs 0 as the error signal B. Then, a control circuit which makes the frequency of the signal D of the VFO 1 be a predetermined value f₀ is constituted by the adder 4, the VFO 1, and the correction circuit 3, and the frequency of the signal D becomes f₀. On the other hand, when the signal A is input, the signal D which is of the predetermined frequency f₀, is synchronized with the input signal A and is obtained at the output of the PLL.

Figure 5 shows the characteristics of the signal D against the signal C of figure 6. That is, the correction signals vₐ, v_{b}, and v_{c} shown in figure 4 are obtained from the correcting circuit 3, and a predetermined frequency f₀ is obtained at a single value (for example, 0) of the control signal C.

However, as is apparent from the curves a, b′, and c′ of figure 5, the control input vs. output frequency characteristics vary dependent on the variations of the characteristics of the VFO 1. That is, in the prior art control apparatus, the variation of the sensitivity of the VFO 1 is not corrected, thereby resulting in poor control.

The present invention is intended as a solution to the problem aforesaid.

In accordance with the invention there is provided a phase locked loop control apparatus comprising:
phase comparator means, responsive to an external input signal and to a controlled variable frequency signal, for detecting the phase difference therebetween, to produce a phase error signal dependant upon the detected phase difference;
control means connected to said phase comparator means, which control means is responsive to said phase error signal and to a frequency correction signal, to produce a first control signal;
a variable frequency signal generating means connected to said control means, which variable frequency signal generating means is responsive to said first control signal, to produce said controlled variable frequency signal; and
a correcting circuit means, connected between the output of said variable frequency signal generating means and said control means, which correcting circuit means is responsive to said controlled variable frequency signal, to produce said frequency correction signal for correcting any deviation of said controlled variable frequency signal from a predetermined value;
which control apparatus is characterised in that:
said control means comprises a multiplier means, responsive to said phase error signal and to said frequency correction signal, to produce as multiplication product thereof a second control signal, wherein said multiplier means is connected, either to said variable frequency signal generating means, or to an adder means which is connected to said signal generating means, whereby said second control signal shall be applied directly, or with the addition of said frequency correction signal, as said first control signal to said signal generating means.

The multiplier means, included as aforesaid, is advantageous since it has the effect that variations or fluctuations in the sensitivity of the variable frequency signal generating means are suppressed.

As indicated above, inclusion of adder means between the multiplier means and the variable frequency signal generating means is optional. This will depend on the nature of the phase error signal applied to the multiplier means. Such adder means can be omitted where this signal has a predetermined constant offset such as produced by some types of phase comparator means, or where a constant offset is added at the phase error signal input to the multiplier.

In two of the preferred arrangements to be described below the phase error signal and the frequency correction signal are applied to the multiplier means via respective resistors and respective low input impedance, high output impedance current input stages. This has the advantage of design flexibility, since the change of the frequency characteristics of the variable frequency signal against the phase error signal can be established arbitrarily and a desired gain can be obtained relatively easily.

Also the current input stages just mentioned can include a differential amplifier and matched current output stages for feedback and external output respectively. This has the advantages that the voltage and the input terminal of the differential amplifier can be held constant and an output current can be obtained even if current at the input terminal should swing negative.

Other advantages will become apparent from the detailed description given hereinafter; it should be understood, however, that the detailed description and specific embodiments are given by way of illustration only, since various changes and modifications within the scope of the invention as defined by the appended claims will become apparent to those skilled in the art from this detailed description.

In the accompanying drawings:
Figure 1 is a block diagram showing a construction of a P.L.L. control apparatus according to a first embodiment of the present invention;
Figure 2 is a block diagram showing a construction of a P.L.L. control apparatus according to a second embodiment of the present invention;
Figure 3 is a circuit diagram showing a construction of an impedance conversion circuit for use in a third embodiment of the present invention;
Figure 4 is a diagram showing the control input vs. output frequency characteristics of a VFO;
Figure 5 is a diagram showing the control input vs. output frequency characteristics of a VFO modified by a known correction of the centre frequency;
Figure 6 is a diagram showing a construction of a known P.L.L. control apparatus;
Figure 7 is a circuit diagram showing a construction of a current mirror circuit; and
Figures 8(a) and (b) are diagrams showing the characteristics of the current mirror circuit of figure 7.

Embodiments of the present invention will be described in detail below with reference to the drawings.

It is intended to make the sensitivity of the VFO constant. That is, to realize that the characteristics a, b′, and c′ of the VFO shown in figure 5 are all equivalent to a.

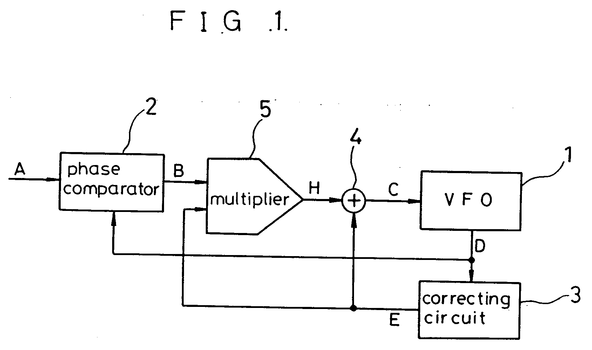

Figure 1 shows a control apparatus according to a first embodiment of the present invention. In figure 1, the same reference numerals designate the same or corresponding elements as those shown in figure 6. Reference numeral 5 denotes a multiplier for multiplying the correction signal E for correcting the deviation of the variable frequency signal D from the predetermined value (f₀) and the phase error signal B as a first control signal. The multiplied output as a second control signal H is input to the adder 4. Herein, the frequency fd of the output signal D against the voltage V_{c} of the input signal C of the VFO 1 is represented by the following formula,${\text{fd = G · V}}_{\text{c}} \text{[Hz]}$
where G is sensitivity of VFO.

The frequency fd of the signal D against the signal H is as shown in figure 5, and vₐ is equal to 0 V. That is, the characteristics of the VFO 1 against the voltage Vₕ of the signal H is represented as in the following.${\text{fd = G ·(V}}_{\text{h}} {\text{+ v}}_{\text{a}} \text{)} {\text{= G · V}}_{\text{h}} {\text{+ G · v}}_{\text{a}}$
Furthermore, the sensitivity G is represented as in the following,${\text{G = fd / V}}_{\text{c}} \text{[Hz/V]}$
and because the correction signal E is a voltage vₐ which makes the signal D a predetermined frequency f₀, the sensitivity G is represented as in the following.${\text{G = f₀ / v}}_{\text{a}}$
From the formulae (2) and (4),$\text{fd =} \frac{\text{f₀}}{{\text{v}}_{\text{a}}} {\text{· V}}_{\text{h}} \text{+ f₀.}$
That is, the sensitivity Gₕ of the VFO 1 against the voltage Vₕ is represented by the following formula.${\text{G}}_{\text{h}} \text{=} \frac{\text{d}}{{\text{d V}}_{\text{h}}} \text{fd =} \frac{\text{f₀}}{{\text{v}}_{\text{a}}}$

The phase error signal B and the correction signal E which is equal to the voltage vₐ are input to the multiplier 5, the voltage Vₕ against the voltage V_{b} of the signal B becomes as follows,${\text{V}}_{\text{h}} {\text{= v}}_{\text{a}} {\text{· V}}_{\text{b}}$

The frequency fd of the signal D which is a variable frequency signal against the voltage V_{b} of the signal B which is the first control signal, is represented as in the following,$\text{fd =} \frac{\text{f₀}}{{\text{v}}_{\text{a}}} {\text{V}}_{\text{h}} \text{+ f₀} {\text{= f₀ · V}}_{\text{b}} \text{+ f₀.}$

That is, even when variations or fluctuations arise in the characteristics of the VFO 1, the characteristics of the frequency of the variable frequency signal against the first control signal becomes constant.

While in the above-illustrated embodiment a control apparatus having an adder 4 is described, the adder may be removed if a predetermined offset value is multiplied on the input signal B of the adder 5. Although this offset value can be obtained by providing an adder which adds a constant value to the signal B between the phase comparator 2 and the multiplier 5, it can be also obtained as a characteristics of the phase comparator 2 itself. For example, in a case where the phase comparator 2 is constituted by mainly a general purpose CMOS logic IC, the output of the IC is 0 V or 5 V which is the power supply voltage of the IC, and the average voltage (which is obtained when the output waveform of IC is smoothed) when the phase error is 0 (corresponding to a case where the control input of figure 5 is equal to 0) becomes 2.5 V. That is, this voltage 2.5 V corresponds to the offset value and in such case the same effects as the above-described embodiment can be obtained without the adder 4.

As is evident from the foregoing description, the PLL circuit of the above-described construction can suppress the variations or fluctuations in the sensitivity of VFO and its characteristics can be made constant. However, this does not always mean that a desired characteristic is obtained. In other words, while a circuit gain which mainly controls the constant characteristics is determined by the multiplier 5, the characteristic of the multiplier 5 is not considered at all. A construction of the control apparatus which can easily establish the characteristics of the multiplier at an arbitrary one is shown in the following.

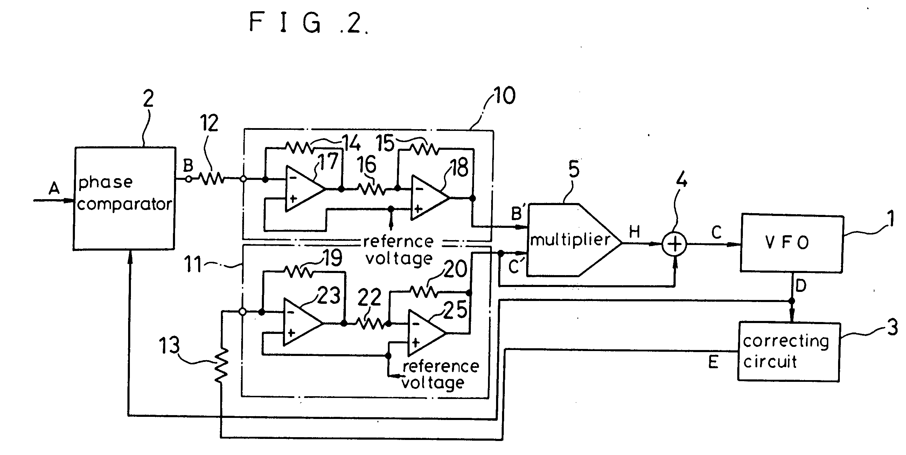

Figure 2 shows a PLL circuit according to a second embodiment of the present invention. In figure 2, the reference numerals denote the same portions as those shown in figure 1. Reference numeral 10 denotes a first current voltage converter (first current input means) constituted by resistors 14, 15, and 16 and amplifiers 17 and 18. Reference numeral 11 denotes a second current voltage converter (second current input means) constituted by resistors 19, 20, and 22 and amplifiers 23 and 25. Reference numerals 12 and 13 denote resistors.

The device will operate as follows.

The current voltage converters 10 and 11 have an input impedance of about 0. The first control signal B from the phase comparator 2 is input to the current-voltage converter 10 via a resistor 12. In the phase comparator 2, the ratio of the voltage V_{B} of the signal B to the phase difference ϑ between the signals A and D, that is, the sensitivity of the phase comparator 2, is Gϑ[V/rad]. The values of the resistors 12 and 13 are assumed to be R₁ and R₂, and the conversion gains of the current voltage converters 10 and 11 to be G₁ [V/A] and G₂ [V/A], respectively. Then, the sensitivity G₃ of the input signal B′ of one input of the multiplier 5 against the phase difference ϑ is represented as follows,$\text{G₃ =} \frac{\text{1}}{\text{R₁}} \text{· Gϑ · G₁.}$
That is, even when the characteristics of the phase comparator 2 and the multiplier 5 are fixed, the characteristics of the PLL circuit can be arbitrarily set by varying the value of the resistor 12.

By appropriately setting the value of the resistor 13 against the frequency correction signal E similarly as above, the characteristics of the frequency correcting operation can be arbitrarily set.

That is, the correction circuit 3 receives the signal D from the VFO 1 and outputs the correction signal E which represents the frequency of the signal D f₀ as a voltage. When the frequency of the signal D is made f_{d} and the voltages V_{E} corresponding to the frequency f₀ and f_{d} are made V₀ and V_{d}, respectively, the sensitivity G_{f} of the correction circuit 3 is represented by the following.${\text{G}}_{\text{f}} \text{=} \frac{{\text{(V}}_{\text{d}} \text{- V₀)}}{{\text{(f}}_{\text{d}} \text{- f₀)}} \text{[V/Hz]}$
Then, the sensitivity G₄ of the other input signal C′ of the multiplier 5 against the frequency difference (f_{d} - f₀) becomes$\text{G₄ =} \frac{\text{1}}{\text{R₂}} {\text{· G}}_{\text{f}} \text{· G₂,}$
and the characteristics can be changed by the value of the resistor 13.

In such embodiment, a stable control can be conducted against the variations of the variable frequency generating means, and the frequency change of the variable frequency signal D against the phase error signal B can be arbitrary set, thereby enabling to obtain a desired gain easily.

While in the above-illustrated embodiment an adder 4 is provided, this adder 4 may be removed if a constant offset value is multiplied on the input signal of the multiplier similarly as in the first embodiment.

While in the above-illustrated embodiment current voltage converters 10 and 11 are used as current input means, these current input means need not be restricted thereto. For example, it may be that the current input means is of a current input and current output type circuit and the multiplier 5 is of a current input type one.

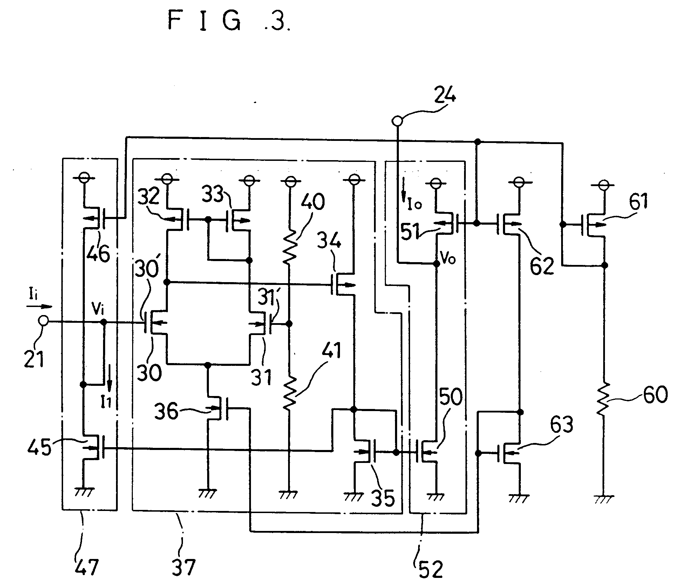

Figure 3 shows a current input circuit of a current input and current output type adopted a third embodiment of the present invention. This current input circuit is an impedance conversion circuit of a type of low input impedance and high output impedance. In figure 3, reference numeral 21 denotes an input terminal to which a current Iᵢ is supplied from the outside. Reference numeral 24 denotes an output terminal. Reference numerals 30, 31, 35, 36, 45, 50, and 63 denote N channel MOS transistors. Reference numerals 32, 33, 34, 46, 51, 61, and 62 denote P channel MOS transistors. Reference numerals 40, 41, and 60 denote resistors. Reference numeral 37 denotes a differential amplifier circuit comprising transistors 30 to 36. Reference numeral 47 denotes a first current outputting stage comprising transistors 45 and 46. Reference numeral 52 denotes a second current outputting stage comprising transistors 50 and 51 whose drains are connected to the external output terminal 24.

The device will operate as follows.

A reference voltage V_{R} (constant voltage) which is obtained by dividing the power supply voltage by the resistors 40 and 41 is given to the first terminal 31′ of the differential amplifier stage 37 (gate of the transistor 31). Furthermore, a voltage Vᵢ which is to be compared with the reference voltage V_{R} is given to the second terminal 30′ (gate of the transistor 30), and a signal corresponding to the difference between the reference voltage V_{R} of the first terminal and the voltage Vᵢ of the second terminal is output as an output signal of the differential amplifier stage 37 from the drain of the transistor 35. Then, the first current outputting stage 47 receives the output signal from the differential amplifier stage 37, and outputs a current I₁ which makes the voltage Vᵢ of the second terminal equal to the reference voltage V_{R}. Thus, the input terminal voltage Vᵢ becomes equal to the reference voltage V_{R} and is kept constant. Such feedback operation which makes the input terminal voltage Vᵢ equal to the reference voltage V_{R} is conducted each time when the input current Iᵢ is input. That is, in order to make the input terminal voltage Vᵢ constant, the input current Iᵢ and the output current I₁ of the first current outputting means are made equal to each other.

Furthermore, to the second current outputting stage 52 having the same electrical characteristics as the first current outputting means 47, the same signal as the output of the first current outputting stage 47 is given from the differential amplifier stage 37. In the second current outputting means 52, the drains of the transistors 51 and 50 are connected to the external output terminal 24 and the output current I₀ of the second current outputting means 52 does not depend on the output terminal voltage V₀. Therefore, the output current I₀ is equal to the output current I₁ of the first current outputting stage 47. Furthermore, as described above, I₁ is equal to Iᵢ and the input current Iᵢ and the output current I₀ of the impedance conversion circuit of this embodiment are made equal to each other.

From the above-described fact, as for the input impedance Zᵢ = (dVᵢ / dIᵢ), the Vᵢ is kept constant to be V_{R} and it is low impedance. As for the output impedance Z₀ = (dV₀ / dI₀), the output current I₀ becomes constant regardless of the output terminal voltage V₀ which is established from the outside while the V₀ changes, thereby making Z₀ infinite, resulting in a high output impedance.

The impedance conversion circuit of the present embodiment does not include such as an operational amplifier. Therefore, with relative to the current input means 10 and 11 of figure 2, the number of elements constituting a circuit can be greatly reduced, thereby minimizing the size of the circuit. This results in an easy mounting in constituting an IC and it is quite effective in view of integration.

Furthermore, when a control apparatus is to be constituted by using the impedance conversion circuit of figure 3, and the current input means 10 and 11 of the PLL circuit of figure 2 which are of a current input and voltage output type, and the multiplier which is of a voltage input type, only the portions comprising the resistors 14 and 15 and the amplifier 17 of the current voltage converter 10, and the resistors 19 and 20 and the amplifier 23 of the current voltage converter 11 may be replaced by the impedance conversion circuit of figure 3.

In order to explain the effects of the impedance conversion circuit of the above-described embodiment, a so-called current mirror circuit which is generally used as a prior art of the present invention will be described.

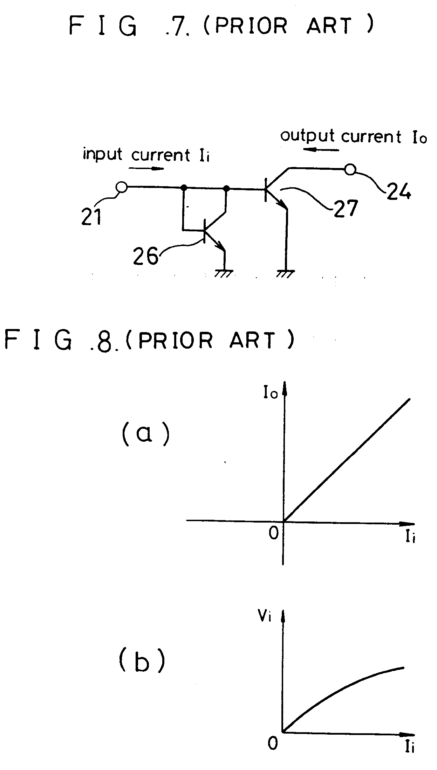

Figure 7 shows a construction of the current mirror circuit. In figure 7, reference numeral 21 denotes an input terminal to which a current Iᵢ is supplied from the outside. Reference numeral 26 denotes a transistor whose collector and base are connected with each other thereby to function as a diode, and this transistor determines the voltage Vᵢ in response to the current Iᵢ. Reference numeral 27 denotes a transistor through which a collector current I₀ flows in accordance with the voltage Vᵢ, and it has the same characteristics as the transistor 26. Reference numeral 24 denotes an output terminal.

The device will operate as follows.

As is well known, the input current Iᵢ and the output current I₀ become to have the same value in the positive value. When Iᵢ is negative, the base of the transistor 27 is not driven as shown in figure 8(b), and the collector current I₀ as shown in figure 8(a), that is, the output current I₀ would not flow. Further, the voltage Vᵢ of the input terminal 21 against the input current Iᵢ is determined by the operation characteristics of the diode of the transistor 26, and a relation shown in figure 8(b) is obtained. This characteristic is similar to that of the diode and is of low impedance. When the voltage V₀ of the output terminal 4 is positive, the output current I₀ becomes constant regardless of the voltage V₀ and becomes sufficiently high impedance. Thus, the prior art current mirror circuit functions as an impedance conversion circuit having a low input impedance and a high output impedance. However, there was a problem that it does not operate when the input current Iᵢ is negative or that the voltage Vᵢ of the input terminal changes dependent on the input current Iᵢ and is not constant. To the contrary, the impedance conversion circuit of the third embodiment of the present invention can make the voltage of the input terminal constant in accordance with the signal by the differential amplifier stage 37, and it is possible to obtain the output current from the external output terminal regardless whether the input current Iᵢ is positive or negative. Therefore, even when the input current Iᵢ is negative, the variation of the voltage Vᵢ of the input terminal against the input current Iᵢ can be suppressed.

While in the above-described embodiment the output current Iᵢ is equal to the input current Iᵢ, the present invention is not restricted thereto. If the Iᵢ and I₀ are in proportion to each other, the present invention can be utilized with the same effects as the above-described embodiment.

## Claims

1. A phase locked loop control apparatus comprising:
phase comparator means (2), responsive to an external input signal (A) and to a controlled variable frequency signal (D), for detecting the phase difference therebetween, to produce a phase error signal (B) dependant upon the detected phase difference;
control means (5; 5,4; 10,11,5; 10,11,5,4) connected to said phase comparator means (2), which control means (5; 5,4; 10,11,5; 10,11,5,4) is responsive to said phase error signal (B) and to a frequency correction signal (E), to produce a first control signal (C);
a variable frequency signal generating means (1) connected to said control means (5; 5,4; 10,11,5; 10,11,5,4), which variable frequency signal generating means (1) is responsive to said first control signal (C), to produce said controlled variable frequency signal (D); and
a correcting circuit means (3), connected between the output of said variable frequency signal generating means (1) and said control means (5; 5,4; 10,11,5; 10,11,5,4), which correcting circuit means (3) is responsive to said controlled variable frequency signal (D), to produce said frequency correction signal (E) for correcting any deviation of said controlled variable frequency signal (D) from a predetermined value;
which control apparatus is characterised in that:
said control means (5; 5,4; 10,11,5; 10,11,5,4) comprises a multiplier means (5; 10,11,5), responsive to said phase error signal (B) and to said frequency correction signal, to produce as multiplication product thereof a second control signal (H), wherein said multiplier means (5; 10,11,5) is connected, either to said variable frequency signal generating means (1), or to an adder means (4) which is connected to said signal generating means (1), whereby said second control signal (H) shall be applied directly, or with the addition of said frequency correction signal (E), as said first control signal (C) to said signal generating means (1).

2. Apparatus as claimed in claim 1 wherein said phase comparator means (2) is responsive to produce a phase error signal (B) including a predetermined offset, and said multiplier means (5; 10,11,5) is connected to said variable frequency signal generating means (1).

3. Apparatus as claimed in claim 1 wherein said control means (5; 10,11,5) includes adder means connected between said phase comparator means (2) and said multiplier means (5; 10,11,5) whereby a constant value offset can be added to said phase error signal (B), and said multiplier means (5; 10,11,5) is connected to said variable frequency signal generating means (1).

4. Apparatus as claimed in claim 1 wherein said control means (5; 5,4; 10,11,5; 10,11,5,4) comprises a first current input means (10) and a second current input means (11), each of low input impedance and high output impedance, which first current input means (10) is connected to said phase comparator means (2) through a first resistor (12), which second current input means (11) is connected to said correcting circuit means (3) through a second resistor (13).

5. Apparatus as claimed in claim 4 wherein at least one of said first and second current input means (10,11) comprises:
a differential amplifier means (37) which is connected at a first terminal (31′) to a source (40,41) of reference voltage (V_{R}), and which is connected at a second terminal (30′) to one of said first and second resistors (12,13), for producing a difference signal corresponding to the difference in voltage of said first and second terminals (31′,30′); and
first and second current outputting means (47,52), having the same electrical characteristics, each responsive to said difference signal, connected between said differential amplifier means (37) and said second terminal (30′) and an output terminal (24), respectively.

## Patentansprüche

1. PLL-Steuereinrichtung mit:
einer Phasenvergleichereinrichtung (2), die auf ein externes Eingangssignal (A) und ein geregeltes Variabelfrequenzsignal (D) anspricht zum Erfassen des Phasenunterschieds dazwischen, damit ein Phasenfehlersignal (B) abhängig von dem erfaßten Phasenunterschied erzeugt wird,
einer Steuereinrichtung (5; 5, 4; 10, 11, 5; 10, 11, 5, 4), die mit der Phasenvergleichereinrichtung (2) verbunden ist, wobei die Steuereinrichtung (5; 5, 4; 10, 11, 5; 10, 11, 5, 4) auf das Phasenfehlersignal (B) und ein Frequenzkorrektursignal (E) zum Erzeugen eines ersten Steuersignals (C) anspricht,
einer Variabelfrequenzsignal-Generatoreinrichtung (1), die mit der Steuereinrichtung (5; 5, 4; 10, 11, 5; 10, 11, 5, 4) verbunden ist, wobei die Variabelfrequenzsignal-Generatoreinrichtung (1) auf das erste Steuersignal (C) zum Erzeugen des geregelten Variabelfrequenzsignals (D) anspricht, und
einer Korrekturschaltungseinrichtung (3), die zwischen den Ausgang der Variabelfrequenzsignal-Generatoreinrichtung (1) und der Steuereinrichtung (5; 5, 4; 10, 11, 5; 10, 11, 5, 4) geschaltet ist, wobei die Korrekturschaltungseinrichtung (3) auf das geregelte Variabelfrequenzsignal (D) zum Erzeugen des Frequenzkorrektursignals (E) anspricht, damit eine Abweichung des geregelten Variabelfrequenzsignals (D) von einem vorbestimmten Wert korrigiert wird,
**dadurch gekennzeichnet, daß**
die Steuereinrichtung (5; 5, 4; 10, 11, 5; 10, 11, 5, 4) eine Multiplizierereinrichtung (5; 10, 11, 5) aufweist, die auf das Phasenfehlersignal (B) und das Frequenzkorrektursignal zum Erzeugen eines zweiten Steuersignals (H) als Multiplikationsprodukt davon anspricht, wobei die Multiplizierereinrichtung (5; 10, 11, 5) entweder an die Variabelfrequenzsignal-Generatoreinrichtung (1) oder an eine Addierereinrichtung (4) angeschlossen ist, die an die Variabelfrequenzsignal-Generatoreinrichtung (1) angeschlossen ist, wodurch das zweite Steuersignal (H) direkt oder mit der Addition des Frequenzkorrektursignals (E) als das erste Steuersignal (C) an die Variabelfrequenzsignal-Generatoreinrichtung (1) angelegt wird.

2. PLL-Steuereinrichtung nach Anspruch 1, **dadurch gekennzeichnet, daß**
die Phasenvergleichereinrichtung (2) zum Erzeugen eines Phasenfehlersignals (B) einschließlich eines vorbestimmten Offsets anspricht und
die Multiplizierereinrichtung (5; 10, 11, 5) an die Variabelfrequenzsignal-Generatoreinrichtung (1) angeschlossen ist.

3. PLL-Steuereinrichtung nach Anspruch 1, **dadurch gekennzeichnet, daß**
die Steuereinrichtung (5; 10, 11, 5) eine Addierereinrichtung enthält, die zwischen der Phasenvergleichereinrichtung (2) und der Multiplizierereinrichtung (5; 10, 11, 5) geschaltet ist, wodurch ein Offset mit konstantem Wert zu dem Phasenfehlersignal (B) addiert werden kann, und
die Multiplizierereinrichtung (5; 10, 11, 5) an die Variabelfrequenzsignal-Generatoreinrichtung (1) angeschlossen ist.

4. PLL-Steuereinrichtung nach Anspruch 1, **dadurch gekennzeichnet, daß**
die Steuereinrichtung (5; 5, 4; 10, 11, 5; 10, 11, 5, 4) eine erste Stromeingabeeinrichtung (10) und eine zweite Stromeingabeeinrichtung (11) jeweils mit geringer Eingangsimpedanz und hoher Ausgangsimpedanz aufweist, wobei die erste Stromeingabeeinrichtung (10) über einen ersten Widerstand (12) an die Phasenvergleichereinrichtung (2) und wobei die zweite Stromeingabeeinrichtung (11) über einen zweiten Widerstand (13) an die Korrekturschaltungseinrichtung (3) angeschlossen ist.

5. PLL-Steuereinrichtung nach Anspruch 4, **dadurch gekennzeichnet, daß** zumindest eine von der ersten und der zweiten Stromeingabeeinrichtung (10, 11)
eine Differenzverstärkereinrichtung (37), die an einem ersten Anschluß (31′) mit einer Quelle (40, 41) einer Referenzspannung (V_{R}) verbunden ist, und die an einem zweiten Anschluß (30′) mit einem von dem ersten und dem zweiten Widerstand (12, 13) angeschlossen ist, damit ein Differenzsignal erzeugt wird, das der Spannungsdifferenz der ersten und zweiten Anschlüsse (31′, 30′) entspricht, und
erste und zweite Stromausgabeeinrichtungen (47, 52) mit denselben elektrischen Eigenschaften aufweist, die jeweils auf das Differenzsignal ansprechen und zwischen der Differenzverstärkereinrichtung (37) und dem zweiten Anschluß (30′) beziehungsweise einem Ausgangsanschluß (24) angeschlossen sind.

## Revendications

1. Appareil de commande pour un circuit à boucle verrouillée en phase comprenant :
un moyen comparateur de phases (2), répondant à signal d'entrée externe (A) et à un signal de fréquence variable contrôlée (D) pour détecter la différence de phase entre eux, afin de produire un signal d'erreur de phase (B) dépendant de la différence détectée de phase ;
un moyen de commande (5 ; 5, 4 ; 10, 11, 5 ; 10, 11, 5, 4) connecté audit moyen comparateur de phases (2), lequel moyen de commande (5 ; 5, 4 ; 10, 11, 5 ; 10, 11, 5, 4) répond audit signal d'erreur de phase (B) et à un signal de correction de fréquence (E), pour produire un premier signal de commande (C) ;
un moyen générateur de signaux à fréquence variable (1) connecté audit moyen de commande (5 ; 5, 4 ; 10, 11, 5 ; 10, 11, 5 , 4), lequel moyen générateur de signaux à fréquence variable (1) répond audit premier signal de commande (C) pour produire ledit signal à fréquence variable contrôlée (D) ; et
un moyen formant circuit de correction (3), connecté entre la sortie dudit moyen générateur de signaux à fréquence variable (1) et ledit moyen de commande (5 ; 5, 4 ; 10, 11, 5 ; 10, 11, 5, 4), lequel moyen formant circuit de correction (3) répond audit signal à fréquence variable contrôlée (D) pour produire ledit signal de correction de fréquence (E) afin de corriger tout écart dudit signal à fréquence variable contrôlée (D) par rapport à une valeur prédéterminée ;
lequel appareil de commande est caractérisé en ce que
ladit moyen de commande (5 ; 5, 4 ; 10, 11, 5 ; 10, 11, 5, 4) comprend un moyen multiplicateur (5 ; 10, 11, 5), répondant audit signal d'erreur de phase (B) et audit signal de correction de fréquence, afin de donner, en tant que produit de multiplication, un second signal de commande (H), où ledit moyen multiplicateur (5 ; 10, 11, 5) est connecté soit audit moyen générateur de signaux à fréquence variable (1) ou à un moyen additionneur (4) qui est connecté audit moyen générateur de signaux (1), ainsi ledit second signal de commande (H) doit être appliqué directement ou avec l'addition dudit signal de correstion de fréquence (E),en tant que ledit premier signal de commande (C), audit moyen générateur de signaux (1).

2. Appareil selon la revendication 1, où ledit moyen comparateur de phase (2) répond pour produire un signal d'erreur de phase (B) comprenant un décalage prédéterminé et ledit moyen multiplicateur (5 ; 10, 11, 5) est connecté audit moyen générateur de signaux à fréquence variable (1).

3. Appareil selon la revendication 1, où ledit moyen de commande (5 ; 10, 11, 5) comprend un moyen additionneur connecté entre ledit moyen comparateur de phase (2) et ledit moyen multiplicateur (5 ; 10, 11, 5), ainsi un décalage d'une valeur constante peut être ajouté audit signal d'erreur de phase (B) et ledit moyen multiplicateur (5 ; 10, 11, 5) est connecté audit moyen générateur de signaux à fréquence variable (1).

4. Appareil selon la revendication 1, où ledit moyen de commande (5 ; 5, 4 ; 10, 11, 5 ; 10, 11, 5, 4) comprend un premier moyen d'entrée de courant (10) et un second moyen d'entre de courant (11), chacun de basse impédance d'entrée et de haute impédance de sortie, lequel premier moyen d'entrée de courant (10) est connecté audit moyen comparateur de phases (2) par une première résistance (12), lequel second moyen d'entrée de courant (11) est connecté audit moyen formant circuit de correction (3) par une seconde résistance (13).

5. Appareil selon la revendication 4, où au moins l'un desdits premier et second moyens d'entrée de courant (10, 11) comprend :
un moyen formant amplificateur différentiel (37) qui est connecté à une première borne (31′) à une source (40, 41) de tension de référence (V_{R}) et qui est connecté à une seconde borne (30′) à l'une desdites première et seconde résistances (12, 13) pour produire un signal de différence correspondant à la différence de tension desdites première et seconde bornes (31′, 30′) ; et
des premier et second moyens de sortie de courant (47, 52) ayant les mêmes caractéristiques électriques, chacun répondant audit signal de différence, connectés entre ledit moyen amplificateur différentiel (37) et ladite seconde borne (30′) et une borne de sortie (24), respectivement.
